# EUROPÄISCHE PATENTANMELDUNG

(11) **EP 1 754 683 A1**
(43) Veröffentlichungstag der Anmeldung: **21.02.2007**
(21) Anmeldenummer: 05017927.4
(22) Anmeldetag: 18.08.2005
(51) Int. Cl.: B81B 3/00, G02B 26/08, B01L 3/00

(54) **Mikro-Elektromechanisches Element**

(71) Anmelder: Fraunhofer-Gesellschaft zur Förderung der angewandten Forschung e.V., 80686 München (DE)
(72) Erfinder: Schenk, Harald, Dr.-Ing., 01139 Dresden (DE)
(74) Vertreter: Pfenning, Meinig & Partner GbR

(57) **Zusammenfassung**

Die Erfindung betrifft Mikro-Elektromechanische Elemente, die vielfältig mit geringfügigen Modifikationen in der Mikromechanik, -optik und auch -fluidik eingesetzt werden können. Sie sollen kostengünstig hergestellt werden können und für verschiedene Applikationen anpassbar sein. Die erfindungsgemäßen Elemente sind dabei so ausgebildet, dass auf einem Substrat eine elastisch verformbare Membran aus einem zumindest bereichsweise elektrisch leitenden Werkstoff so befestigt ist, dass zwischen Substrat und Membran ein Hohlraum oder ein Spaltbereich mittels Abstandshaltern ausgebildet ist. Ein oder mehrere Abstandshalter sind aus einem dielektrischen polymeren Werkstoff gebildet. Am Substrat ist mindestens ein Kontaktelement vorhanden, das an eine elektrische Spannungsquelle angeschlossen ist.

## Beschreibung

Die Erfindung betrifft Mikro-Elektromechanische Elemente, die vielfältig mit geringfügigen Modifikationen in der Mikromechanik, -optik und auch -fluidik eingesetzt werden können. So können beispielsweise kleine optische Elemente mit beeinflussbarer Brennweite oder auch Mikropumpen zur Verfügung gestellt werden, die einen Betrieb mit kleiner Zeitkonstante ermöglichen.

So ist es bekannt, so genannte "Silicon on Insulator" für die Herstellung ähnlicher Elemente einzusetzen. Dabei ist ein Substrat aus Silizium mit einer Oxidschicht gegenüber einer Deckschicht, die wiederum aus Silizium gebildet ist, elektrisch isoliert. Die Dicke der Isolierschicht ist dabei auf wenige hundert Nanometer bis maximal 3 µm begrenzt, was elektrisch eine ausreichende Schichtdicke darstellt. Für einige elektromechanische Anwendungen ergeben sich aber Grenzen, bzgl. bestimmter gewünschter zu erreichender Parameter. Auch eine Anpassung an bestimmte Applikationen ist mit solchen Vorprodukten nicht ohne weiteres möglich.

Es ist daher Aufgabe der Erfindung Mikro-Elektromechanische Elemente zur Verfügung zu stellen, die einfach und kostengünstig herstellbar und an unterschiedliche Applikationen anpassbar sind.

Erfindungsgemäß wird diese Aufgabe mit Mikro-elektromechanischen Elementen, die die Merkmale des Anspruchs 1 aufweisen gelöst. Vorteilhafte Ausgestaltungen und Weiterbildungen der Erfindung können mit den in den untergeordneten Ansprüchen bezeichneten Merkmalen gelöst werden.

So ist bei einem erfindungsgemäßen Element ein Substrat, das quasi einen Träger mit erhöhter Steifigkeit, bildet mit einer elastisch verformbaren Membran mittels eines oder mehrerer Abstandshalter verbunden, so dass zwischen Substrat und Abstandshalter(n) ein Hohlraum oder ein Spaltbereich ausgebildet ist. Dadurch kann eine elastische Verformung der Membran erreicht und diese ausgenutzt werden. Abstandshalter sollen aus einem dielektrischen polymeren Werkstoff gebildet werden.

Die Membran besteht aus einem halbleitenden Werkstoff, beispielsweise Silizium. Für eine gezielte elastische Verformung der Membran ist am Substrat mindestens ein Kontaktelement vorhanden, das mit einem vorgebbaren auch variabel einstellbaren elektrischen Spannungspotential beaufschlagt werden kann.

Bevorzugt sind aber mehrere Kontaktelemente am Substrat vorhanden, die wiederum besonders bevorzugt jeweils einzeln angesteuert werden können sollen. Durch die Anordnung und gezielte Ansteuerung von Kontaktelementen kann auch die jeweilige elastische Verformung, was die Verformungsgeometrie und die maximale Verformung betrifft, beeinflusst werden.

Die Beeinflussung der Verformung der Membran kann aber auch durch die Anordnung, Gestaltung und/oder Dimensionierung des/der Abstandshalter und/oder die Gestaltung der elastisch verformbaren Membran erreicht werden.

So können mindestens zwei Abstandshalter in einem Abstand zueinander angeordnet sein, auf denen die Membran in einem äußeren Randbereich aufgesetzt ist. Die Membran kann zwischen den Abstandshaltern, durch den zwischen Substratoberfläche und Membran vorhandenen Spaltbereich, elastisch verformt werden, wenn eine elektrische Spannung an einem oder mehreren Kontaktelement(en) am Substrat angelegt ist.

Die Membran kann so zwischen den Abstandshaltern konkav verformt werden, wobei die Verformung auch mit einer bestimmten oder variablen Frequenz durchführbar ist.

Ein Abstandshalter kann aber auch als randseitig geschlossenes Gebilde, beispielsweise in Form eines Kreisringes oder mit anderer gewünschter Geometrie, ausgebildet sein, so dass zwischen Membran und Substrat ein Hohlraum ausgebildet ist, in dessen Bereich eine elastische Verformung der Membran möglich ist. Dadurch kann beispielsweise das Innenvolumen des Hohlraumes temporär verändert werden.

Durch die elastische Verformung einer Membran verändert sich aber in jedem Fall die Krümmung der Membranoberflächen, die sich optisch ausnutzen lässt.

Trifft elektromagnetische Strahlung auf eine Membranoberfläche wirken sich die entsprechenden Einfallswinkel auf die Membranoberfläche aus und es erfolgt eine entsprechende Brechung oder Reflexion der elektromagnetischen Strahlung. Für eine Reflexion sollte die nach außen weisende Oberfläche der Membran mit einer für die Reflexion geeigneten Beschichtung versehen sein.

So kann ein erfindungsgemäßes Element einen sphärischen oder auch asphärischen Spiegel mit unterschiedlicher Brennweite bilden.

Hierfür aber auch für andere Applikationen, können eine oder mehrere Abstandshalter eine unterschiedliche Dicke oder Höhe aufweisen, so dass der Abstand zwischen Membran und Substratoberfläche unterschiedlich groß ist.

Die Membran kann aber auch eine unterschiedliche Dicke aufweisen, wodurch die Verformbarkeit der Membran lokal differenziert beeinflusst werden kann.

So besteht aber auch die Möglichkeit einen bestimmten Winkel der nach außen weisenden Oberfläche der Membran im nicht sowie im verformten Zustand der Membran zu erreichen.

Membranen können dabei zumindest bereichsweise und/oder an einer Oberfläche bereits konkav bzw. konvex gekrümmt sein.

Es kann/können an einer Membran auch eine oder mehrere Vertiefung(en) ausgebildet sein, die dann Festkörpergelenke oder Federelemente bilden können.

In diesem Fall wirkt sich eine die Anordnung der Festkörpergelenke bzw. Federelemente berücksichtigende Anordnung von Kontaktelementen besonders bevorzugt aus.

Substrate können aus Silizium oder einem Glas zur Verfügung gestellt werden. Für die Membran sollte zumindest bereichsweise ein elektrisch leitender Werkstoff, beispielsweise in geeigneter Form dotiertes Silizium eingesetzt werden. Die Membran sollte eine Dicke von mindestens 50 nm bis hin zu 1000 µm aufweisen. Der Abstand zwischen Membran und Substratoberfläche sollte mindestens 100 nm im nicht verformten Zustand der Membran betragen.

Die elastisch verformbare Fläche der Membran zwischen einem oder mehreren Abstandshalter(n) sollte bei ca. 5 mm² gewählt werden.

Bevorzugt sollten die Kontaktelemente als Durchkontaktierung von der Rückseite des Substrates aus- und durch dieses hindurchgehend, beispielsweise als "vias" oder "TWI" ausgebildet sein. Dadurch kann eine kleine erforderliche Fläche für die Kontaktelemente und die Kontaktanschlüsse von der Rückseite sowie eine optimierte lokal gezielte Anordnung von Kontaktelementen erreicht werden.

Bei der Herstellung erfindungsgemäßer Elemente kann so vorgegangen werden, dass auf einer Substratoberfläche eine Polymerschicht mit vorgebbarer Schichtdicke aufgebracht wird, was in an sich bekannter Dünnschichttechnik erfolgen kann. Der Spaltbereich bzw. die Hohlraumgeometrie kann mittels ebenfalls bekannter Strukturierungstechniken ausgebildet werden, wobei dies vor aber auch nach dem Aufsetzen der elastisch verformbaren Membran durchführbar ist.

Zur Ausbildung eines ggf. aber auch mehrerer Hohlraumes/-räume können dann durch die Membran und/oder das Substrat hindurch reichende Durchbrechungen, beispielsweise Gräben ausgebildet werden. Über diese Durchbrechungen kann durch Ätzen und Unterätzen Polymer entfernt und so ein Hohlraum ausgebildet werden.

Zwischen benachbarten Durchbrechungen verbleiben Stege aus dem Membran- oder Substratwerkstoff, die eine ausreichende Restfestigkeit aufweisen. Dabei kann auch Polymer unterhalb dieser Stege entfernt und dort Hohlraum ausgebildet werden. Durch z.B. Trockenätzen kann mindestens die halbe Stegbreite unterätzt und dort Polymer entfernt werden, so dass die Abstände benachbarter Durchbrechungen entsprechend gewählt werden können.

Durchbrechungen können aber auch gefüllt werden, um dann eine Ätzstoppschicht zu erhalten und bestimmte Bereiche vor dem jeweiligen Ätzmedium zu schützen und dort eine Entfernung von Polymer zu verhindern. So kann beispielsweise ein Abstandshalter, der einen äußeren Rahmen bildet, erhalten werden.

Durchbrechungen können aber nicht nur die Ausbildung und Gestaltung von Hohlräumen ermöglichen. Durch entsprechende Anordnung, Dimensionierung und geometrische Gestaltungen können auch mechanische und elektrische Eigenschaften in jeweils gewünschter Form beeinflusst werden. So kann beispielsweise das Verformungsverhalten einer Membran beeinflusst werden. Es besteht aber auch die Möglichkeit lokal gezielt elektrostatische oder elektromagnetische Kräfte wirken zu lassen, um eine entsprechende Auslenkung einer Membran hervorzurufen.

Substrat und Membran sollten bevorzugt stoffschlüssig mittels des Polymers stoffschlüssig miteinander verbunden sein.

Geeignete Polymere sind beispielsweise Polyimid, BCB, Photolack, POM, PMMH, LCP, PVDF, PSU,PEEK, PP oder PC.

Es ist auch möglich an die Membran ein bestimmtes elektrisches Spannungspotential anzulegen, wodurch sich eine quasi Vorspannung der Membran erreichen lässt, die sich auf eine infolge der an Kontaktelemente angelegten elektrischen Spannung auf die jeweilige Verformung der Membran auswirken kann.

Insbesondere wenn mit einem Abstandshalter ein Hohlraum zwischen Membran und Substrat ausgebildet ist, kann ein erfindungsgemäßes Element eine Mikrofluidpumpe bilden. Dabei sollte mindestens eine Ein- und eine Auslassöffnung zum Hohlraum geführt sein, durch die ein Fluid bei Kontraktion und Dekontraktion des Hohlraums durch entsprechende elastische Verformung der Membran angesaugt und komprimiert werden kann. Dabei können kleine Volumenströme mit hoher Frequenz gezielt gehandhabt werden.

Außerdem können mehrere Hohlräume eines oder mehrerer Elemente(s) miteinander verbunden sein und eine Kaskade bilden, so dass Fluid von einem Hohlraum aus dessen Auslassöffnung über die Einlassöffnung eines nachfolgenden Hohlraumes gepumpt werden kann. Dadurch kann die Pumpleistung variiert werden. So können Hohlräume unterschiedliche Innenvolumina aufweisen und/oder Membranen sich unterschiedlich elastisch verformen lassen.

In einer Ausgestaltung kann eine Membran auch eine Überlappung im äußeren Randbereich aufweisen, die über Abstandshalter hinausragt. Dabei kann zwischen der Überlappung und der Substratoberfläche ebenfalls ein Spalt vorhanden sein, so dass auch eine Verformbarkeit der Überlappung oder eines Teils davon möglich ist.

In diesem Fall kann am Substrat mindestens ein weiteres Kontaktelement im Bereich der Überlappung angeordnet sein. Bei Anlegen einer entsprechenden elektrischen Spannung an ein oder mehrere Kontaktelement(e) kann auch eine elastische Verformung der Überlappung erreicht werden. Die Überlappung bildet einen Hebelarm bis zum Abstandshalter, so dass entgegengesetzt gerichtete Kräfte und Momente auf den übrigen Teil der Membran wirken und eine entsprechende elastische Verformung hervorrufen.

Nachfolgend soll die Erfindung beispielhaft näher erläutert werden.

Dabei zeigen:
Figur 1 in schematischer Form eine Schnittdarstellung eines Beispiels gemäß der Erfindung;
Figur 2 ein Beispiel für die Ausbildung eines Mikro-Elektromechanischen Elementes in zwei Schritten;
Figur 3 ein Beispiel mit geschütztem Rahmenbereich;
Figur 4 eine weiteres Beispiel eines Mikro-Elektromechanischen Elementes und
Figur 5 ein Beispiel mit einer Segmentierung.

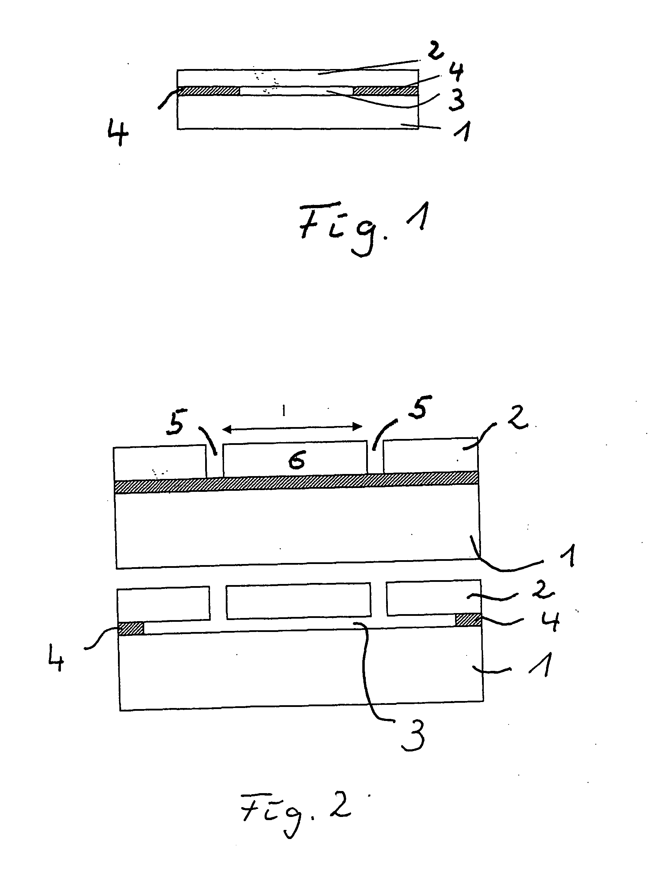

In Figur 1 ist in schematischer Form und im Schnitt ein Beispiel eines Mikro-Elektromechanischen Elementes gezeigt. Die Membran 2 und das Substrat 1 sind aus n- oder p-dotiertem Silizium gebildet. Zwischen Membran 2 und Substrat sind bei diesem Beispiel am äußeren Rand Abstandshalter 4 aus Polyimid gebildet worden. Der Hohlraum 3 wurde durch Entfernung von Polyimid über Öffnungen auf der Vorderseite durch Trockenätzen ausgebildet, so dass bei auf die Membran 2 wirkenden Kräften ihre Auslenkung unter Berücksichtung des Spaltmaßes zwischen Membran 2 und Substrat 1 möglich wird.

Mit Figur 2 soll eine Möglichkeit für die Ausbildung und Herstellung erfindungsgemäßer Elemente aufgezeigt werden. Hierbei wurden Durchbrechungen 5 durch die Membran 2 durch Ätzen ausgebildet. Die Durchbrechungen 5 sind durch die Dicke der Membran 2 bis hin zum Polyimid geführt, wie der oberen Darstellung von Figur 2 entnommmen werden kann.

Danach wird weiter geätzt, so dass auch aus Bereichen unterhalb des verbliebenen Membranwerkstoffes Polyimid entfernt worden ist. Im äußeren Randbereich nicht entferntes Polyimid bildet Abstandshalter 4 zwischen Membran 2 und Substrat 1. Dabei sollte der Abstand benachbarter Durchbrechungen 5 so gewählt werden, dass Polyimid unterhalb der zwischen diesen Durchbrechungen verbliebenen Stege 6 in der Membran 2 vollständig entfernt werden kann. Dies ist über eine Durchbrechung 5 bis zur halben Breite (L/2) eines solchen Steges 6 möglich. Dabei kann L in der Größenordnung von mehreren hundert µm bis einigen mm liegen. Dadurch kann auch eine große Membranfläche unterätzt werden.

Nach der Ausbildung eines Hohlraumes 3 oder eines Spaltes können Durchbrechungen 5 mit einem geeigneten Stoff verfüllt und so die Durchbrechungen 5 geschlossen bzw. eine ebene Oberfläche der Membran 2 wieder hergestellt werden.

Es ist auch möglich bei Rahmen bildenden Abstandshaltern 4, beispielsweise mittels elektrostatischer oder elektromagnetischer Kräfte, einen solchen Rahmen ebenfalls auslenken zu können.

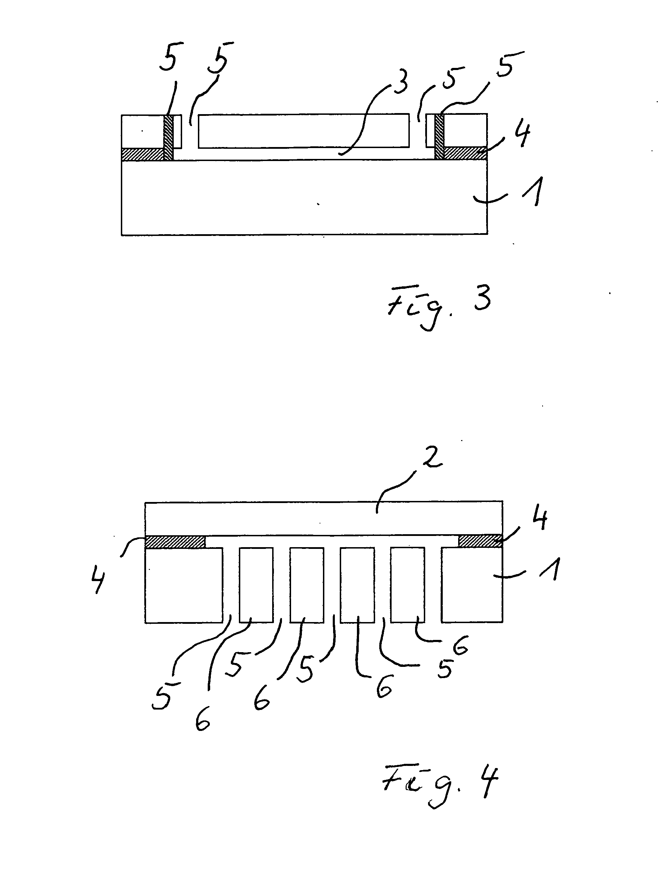

Figur 3 zeigt eine Möglichkeit eine gezielte lokale Begrenzung der Entfernung von Polyimid, als Beispiel für einen dielektrischen polymeren Werkstoff.

Dabei wurden die beiden äußeren Durchbrechungen 5 mit einem anorganischen Stoff ausgefüllt, so dass dieser eine Ätzstoppschicht bilden kann. Über die dazwischen angeordneten, offen gebliebenen Durchbrechungen 5 konnte das Polyimid unterhalb der Membran 2 entfernt und ein Hohlraum 3 oder ein offener Spalt ausgebildet werden. Das am äußeren Rand nicht entfernte Polyimid bildet wieder Abstandshalter 4.

Substrate 1 können z.B. über Bondpads und Membranen 2 mittels elektrisch leitender Klebstoffe elektrisch leitend kontaktiert werden, über die dann wieder eine Auslenkung einer Membran 2 mittels auf diese wirkender Kräfte hervorgerufen werden kann.

Membranen 2 können aber auch zumindest bereichsweise eine ausreichende Festigkeit und Steifigkeit aufweisen, die eine elastische Verformung dieser Bereiche vermeiden. Mit einer geeigneten Randkontur können dann Mikroelektromechanische Elemente als Torsionsspiegel oder auch Translationsspiegel ausgebildet werden. Dabei sollten Bereiche der Membran 2 um den Flächenschwerpunkt steifer und fester sein und am äußeren Rand Federelemente ausgebildet sein.

Mit Figur 4 soll eine weiter Möglichkeit für die Ausbildung und Herstellung erfindungsgemäßer Elemente verdeutlicht werden.

Hier wurden Durchbrechungen 5 durch das Substrat 1 hindurch durch Trockenätzen ausgebildet und das Polyimid dann nachfolgend von der Rückseite des Elementes zur Ausbildung eines Hohlraumes 3 ebenfalls durch Ätzen entfernt. Dies erschließt die Möglichkeit eine geschlossene Membran 2 an der Frontseite eines Elementes beizubehalten. Bei einer solchen Ausbildung ist ein größerer Gestaltungsspielraum gegeben, da die Durchbrechungen 5 (Gräben) nahezu beliebig angeordnet, gestaltet und dimensioniert werden können.

Im Übrigen treffen auch auf ein solches Beispiel die zum Beispiel nach Figur 2 getroffenen Äußerungen zu.

Es ist aber auch eine Kombination der Beispiele nach den Figuren 2 und 4 möglich. Es können demzufolge Durchbrechungen 5 in Membran 2 und auch Substrat 1 ausgebildet worden sein, wobei diese dann möglichst in versetzter Anordnung zueinander ausgebildet werden sollten.

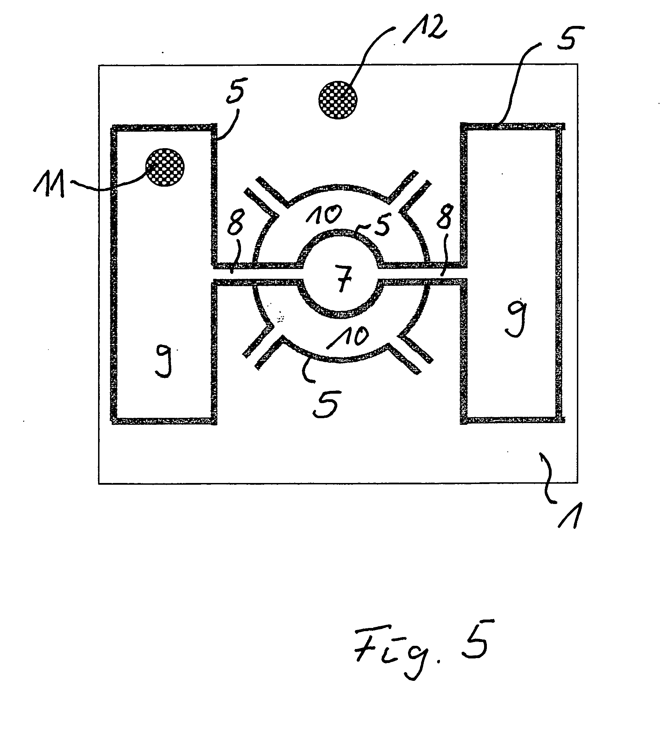

Mit dem Beispiel nach Figur 5 sollen Möglichkeiten aufgezeigt werden, wie ein vorgebbares Deformationsprofil einer Membran 2 erhalten werden kann. Dabei kann das Substrat 1 mittels Durchbrechungen 5 segmentiert werden. Die Durchbrechungen 5 sind dabei in Form von in bestimmter Form geometrisch gestalteter Gräben ausgebildet.

Bei dem gezeigten Beispiel ist ein inneres kreisförmiges Segment 7, das bezogen auf das Element direkt mittig unterhalb einer hier kreisförmigen Membran 2 angeordnet ist, vorhanden.

Über die in der Darstellung zwei nach links und rechts verlaufenden Arme 8 wird eine elektrisch leitende Verbindung zu den größeren rechteckigen Flächen 9 am Rand hergestellt. Da die rechteckigen Flächen 9 in x- und y-Richtung eine größere flächenmäßige Ausdehnung aufweisen, als die Breite des Segmentes 7, wird dieser Bereich nicht vollständig unterätzt. Dadurch verbleibt Polymer, als Abstandshalter 4 im Bereich der rechteckigen Flächen 9. Das Polymer im Bereich des Segmentes 7 ist aber zwischen Membran 2 und Substrat 1 vollständig entfernt. Die rechteckigen Flächen 9 sind aber noch über das Polyimid, als Polymer, mit der Membran 2 verbunden und so gehalten.

Außerdem sind zwei elektrische Kontakte 11 und 12 vorhanden, wobei der Kontakt 11 am Substrat 1 als Lötbump ausgebildet sein kann.

Mittels der zwei konzentrischen Halbbögen, die an jeweils zwei Punkten unterbrochen sind, kann ein weiteres Segment 10 um das innere Segment 7 ausgebildet werden. Es besteht aber noch eine mechanische Verbindung an diesen Punkten, so dass auch eine elektrisch leitende Verbindung in Richtung äußeres gegeben ist. Auch das Segment 10 ist über die größeren äußeren Flächenbereiche und das dort nicht entfernte Polymer mit der Membran 2 mechanisch stabilisiert.

Auch an diesem Segment 10 ist ein elektrischer Kontakt 12 vorhanden.

Die Segmente 7 und 10 sind voneinander elektrisch isoliert und können dadurch unabhängig voneinander gegenüber der Membran 2 mit einer elektrischen Spannung beaufschlagt werden. Bei entsprechend gewählten elektrischen Spannungen kann das Profil mit der die Membran 2 verformt wird in Grenzen beeinflusst werden.

Dies ist auch durch eine höhere Anzahl von entsprechend ausgebildeten Segmenten möglich.

Hier kann auch eine Kombination von Segmenten 7 und 10 oder mehr an der Rückseite mit Durchbrechungen 5 in der Membran 2, die ggf. auch gefüllt worden sein können, ähnliche Effekte hervorrufen.

## Patentansprüche

1. Mikro-Elektromechanisches Element bei dem auf einem Substrat eine elastisch verformbare Membran aus einem zumindest bereichsweise elektrisch leitenden Werkstoff so befestigt ist, dass zwischen Substrat (1) und Membran (2) ein Hohlraum (3) oder ein Spaltbereich mittels eines oder mehrerer Abstandshalter(s) (4) aus einem dielektrischen polymeren Werkstoff ausgebildet ist und am Substrat (1) mindestens ein Kontaktelement (11, 12), das/die an eine elektrische Spannungsquelle angeschlossen ist/sind, vorhanden ist/sind.

2. Element nach Anspruch 1, **dadurch gekennzeichnet, dass** mehrere Kontaktelemente (11, 12) jeweils einzeln ansteuerbar sind.

3. Element nach Anspruch 1 oder 2, **dadurch gekennzeichnet, dass** Kontaktelemente (11, 12) und/oder Segmente (7, 10) für eine lokal definierte elastische Verformung der Membran (2) am Substrat (1) angeordnet und/oder ausgebildet sind.

4. Element nach einem der vorhergehenden Ansprüche, **dadurch gekennzeichnet, dass** mindestens zwei Abstandshalter (4) in einem Abstand zueinander angeordnet sind.

5. Element nach einem der vorhergehende Ansprüche, **dadurch gekennzeichnet, dass** im Substrat (1) und/oder der Membran (2) zwischen Stegen (6) Durchbrechungen (5) ausgebildet sind.

6. Element nach einem der vorhergehenden Ansprüche, **dadurch gekennzeichnet, dass** mit grabenförmigen Durchbrechungen (5) Segmente (7, 10) ausgebildet sind.

7. Element nach einem der vorhergehenden Ansprüche, **dadurch gekennzeichnet, dass** Durchbrechungen (5) mit einem eine Ätzstoppschicht bildenden Stoff befüllt sind.

8. Element nach einem der vorhergehenden Ansprüche, **dadurch gekennzeichnet, dass** ein oder mehrere Abstandshalter (4) eine unterschiedliche Dicke/Höhe aufweisen.

9. Element nach einem der vorhergehenden Ansprüche, **dadurch gekennzeichnet, dass** das Substrat (1) mit Silizium oder einem Glas und die Membran (2) ,mit Silizium gebildet sind.

10. Element nach einem der vorhergehenden Ansprüche, **dadurch gekennzeichnet, dass** die Membran (2) eine nicht konstante Dicke aufweist.

11. Element nach einem der vorhergehenden Ansprüche, **dadurch gekennzeichnet, dass** die Membran (2) zumindest bereichsweise konkav oder konvex gewölbt ist.

12. Element nach einem der vorhergehenden Ansprüche, **dadurch gekennzeichnet, dass** an der Membran (2) Festkörpergelenke oder Federelemente ausgebildet sind.

13. Element nach einem der vorhergehenden Ansprüche, **dadurch gekennzeichnet, dass** die Membran (2) und das Substrat (1) mit dem Abstandshalter (4) bildenden Polymer stoffschlüssig verbunden sind.

14. Element nach einem der vorhergehenden Ansprüche, **dadurch gekennzeichnet, dass** mit einem in Schichtform auf dem Substrat (1) ausgebildeten Abstandshalter (4) ein am äußeren Rand allseitig geschlossener Hohlraum zwischen Substrat (1) und Membran (2) ausgebildet ist.

15. Element nach einem der vorhergehenden Ansprüche, **dadurch gekennzeichnet, dass** zwischen Substrat (1) und Membran (2) im nicht verformten Zustand der Membran (2) ein Abstand von mindestens 100 nm eingehalten ist.

16. Element nach einem der vorhergehenden Ansprüche, **dadurch gekennzeichnet, dass** zu einem Hohlraum (3) mindestens eine Ein- und eine Auslassöffnung geführt sind.

17. Element nach einem der vorhergehenden Ansprüche, **dadurch gekennzeichnet, dass** die nach außen weisende Oberfläche der Membran (2) mit einer elektromagnetische Strahlung reflektierenden Beschichtung versehen ist.

18. Element nach einem der vorhergehenden Ansprüche, **dadurch gekennzeichnet, dass** Kontaktelemente am Substrat (1), als Durchkontaktierung durch das Substrat (1) hindurch, ausgebildet sind.

19. Element nach einem der vorhergehenden Ansprüche, **dadurch gekennzeichnet, dass** mindestens eine Einlassöffnung eines Elementes mit einer Auslassöffnung eines weiteren Elementes verbunden ist.

20. Element nach einem der vorhergehenden Ansprüche,
**dadurch gekennzeichnet, dass** die Membran (2) mit einem elektrischen Spannungspotential beaufschlagt ist.

21. Element nach einem der vorhergehenden Ansprüche, **dadurch gekennzeichnet, dass** die Membran (2) zumindest bereichsweise an ihrem äußeren Rand eine Überlappung, die über den/die Abstandshalter (4) hinausragt, aufweist.

22. Element nach einem der vorhergehenden Ansprüche,
**dadurch gekennzeichnet, dass** am Substrat (1) Kontaktelemente im Bereich der Überlappung der Membran (2) angeordnet sind.
